# EUROPEAN PATENT SPECIFICATION

(11) **EP 3 840 106 B1**
(45) Date of publication and mention of the grant of the patent: **08.06.2022**
(21) Application number: 20214625.4
(22) Date of filing: 16.12.2020
(51) Int. Cl.: H01M 10/48, G01K 13/00, G01R 19/165, G01R 31/00, G01R 31/385, H01M 10/42

(54) **BATTERY PACK DIAGNOSTIC METHOD AND BATTERY PACK DIAGNOSTIC DEVICE**
BATTERIESATZDIAGNOSEVERFAHREN UND BATTERIESATZDIAGNOSEVORRICHTUNG
PROCÉDÉ ET DISPOSITIF DE DIAGNOSTIC DE BLOC-BATTERIE

(30) Priority: 17.12.2019 CN 201911301100
(43) Date of publication of application: 23.06.2021
(73) Proprietor: Globe (Jiangsu) Co., Ltd., Zhonglou District Changzhou, Jiangsu 213023 (CN)
(72) Inventor: LI, Baoan, Changzhou, Jiangsu 213023 (CN); ZHU, Yanliang, Changzhou, Jiangsu 213023 (CN); ZHUANG, Xian, Changzhou, Jiangsu 213023 (CN)
(74) Representative: Bergenstråhle & Partners AB

(56) References cited:
- WO-A1-2013/046978
- CN-U- 209 542 809
- US-A1- 2017 038 433

## Description

### Cross-Reference to Related inventions

This invention claims the priority of CN application Serial No. 201911301100.7, filed on December 17, 2019

### Technical field

The present invention relates to a battery pack diagnostic method and a battery pack diagnostic device using the battery pack diagnostic method.

### Background art

At present, lithium battery packs have been widely used in various power tools as a power source. However, the battery pack is due to charged and discharged frequently and working under great intensity, and the limitations of the battery pack's own volume, operating conditions, manufacturing cost and other factors, the battery pack is prone to be damaged, and the fault location is difficult to judged and so on. Once a fault occurs, it is difficult for users to troubleshoot the failure, and more often seek help from the seller or maintenance service site. However, the professional knowledge of the sellers and maintenance service site staff is limited. They usually transfer the repair pressure to the equipment manufacturer, such as returning to the factory for servicing. If only for some minor reasons or some simple component failures, the product is sent back to the factory for repair, it will not only increase the maintenance cost, but also make the user wait a long time, thereby reducing the user's experience. Prior art documents CN209 542 809, US2017/038433, WO2013/046978 disclose systems and methods for fault detection of battery cells.

Secondly, after the battery pack fails, the current commonly used judging method is to use a matching charger and discharging tool to charge and discharge the battery pack for a short period of time, so as to carry out a rough qualitative by the failure phenomenon of the battery pack during the charging and discharging process. Then, disassemble the battery pack for further analysis. Although this method of operation is simple, it has some drawbacks. First of all, this method has detection limitations. Some faults cannot be seen by a short-time charging and discharging, e.g. charging MOS drain-source short-circuited. Secondly, this method cannot accurately locate the fault location, for example, when the matching charger is abnormally charged, the fault location cannot be determined. Finally, the diagnostic efficiency of this method is relatively low, which even needs maintenance personnel to charge and discharge multiple times to determine the fault type and fault location of the battery pack, which seriously reduces the work efficiency of the maintenance personnel.

In view of the above, It is necessary to provide a battery pack diagnostic method and a battery pack diagnosis device using the battery pack diagnostic method to solve the above problems.

### Summary of invention

The objective of the present invention is to provide a battery pack diagnostic method and a battery pack diagnostic device using the battery pack diagnostic method. The battery pack diagnostic method could detect the battery pack quickly and comprehensively, and locate the fault accurately which improves the work efficiency of the maintenance personnel.

In order to achieve the object, the present invention provides a battery diagnostic method, which is implemented to diagnose the battery pack when the battery pack is inserted into the battery pack diagnostic device, the method comprises following steps without specific order:
S1: detecting a battery temperature and an ambient temperature of the battery pack; if the difference between the two temperatures is less than a preset temperature threshold, the state of temperature of the battery pack is instructed as normal, if not, the state of temperature of the battery pack is instructed as abnormal;
S2: detecting a pre-load voltage of a discharge port of the battery pack before loading and a post-load voltage after loading; if the difference between the two voltages is less than a preset voltage threshold, the state of discharging circuit of the battery pack is instructed as normal, if not, the state of discharging circuit of the battery pack is instructed as abnormal;
S3: detecting a charge voltage of a charge port of the battery pack and a discharge voltage of the discharge port; if the two voltages are equal, the state of charging circuit of the battery pack is instructed as normal, if not, the state of charging circuit of the battery pack is instructed as abnormal;
S4: detecting whether a hot-plugging interface of the battery pack has a hot-plugging signal; if the hot-plugging interface of the battery pack has the hot-plugging signal, the state of hot-plugging interface of the battery pack is instructed as normal, if not, the state of hot-plugging interface of the battery pack is instructed as abnormal.

As a further improvement of the invention, wherein the step S3 further comprises a step S31: detecting whether a charging MOS tube could be turned off; if the charging MOS tube could be turned off, the state of charging circuit of the battery pack is instructed as normal, if not, the state of charging circuit of the battery pack is instructed as abnormal.

As a further improvement of the invention, the step S1 further comprises a step S11: determining whether the battery pack has been working for a preset time; if so, detecting the battery temperature of the battery pack, if not, detecting the battery temperature of the battery pack after the battery pack has been working for the preset time.

As a further improvement of the invention, the battery diagnostic method further comprises a step S5: storing the temperature detection information, the discharging circuit detection information, the charging circuit detection information, and the hot-plugging interface detection information.

As a further improvement of the invention, the preset temperature threshold is 1°C, 3°C, 5°C, 7°C or 9°C, preferably 3°C.

As a further improvement of the invention, the preset voltage threshold is 0.5V, 1V, 1.5V, 2V, 2.5V or 3V, preferably 1V.

As a further improvement of the invention, the preset time is 10 min, 15 min, 20 min or 30 min, preferably 15 min.

In order to achieve the object, the present invention also provides a battery pack diagnostic device comprising: a temperature detection module comprising an information acquisition circuit for reading a battery temperature information of the battery pack and a temperature detection circuit for detecting an ambient temperature; a discharge detection module comprising a discharge loading circuit for providing a load to a discharge port and a discharge port voltage sampling circuit; a charge detection module comprising a charge voltage sampling circuit;
a hot-plugging detection module comprising a hot-plugging detection circuit for detecting whether a hot-plugging port has a hot-plugging signal; and
a controlling module to control the temperature detection module, the discharge detection module, a charge detection module and a hot-plug detection module, to detect whether the battery pack is normal through the battery pack diagnostic method.

As a further improvement of the invention, the battery pack diagnostic device further comprises a communicating module for communication with an external equipment.

As a further improvement of the invention, the communication module is WLAN module, Blue Tooth module, 5G communication module, infrared communication module or USB interface.

As a further improvement of the invention, the battery pack diagnostic device further comprises a storage module for storing diagnostic informations.

As a further improvement of the invention, Q5 and Q4 are MOS tubes in the discharge loading circuit which is used as switches in the circuit in order to load the battery discharge port voltage P+ to the resistors RA1 and RA9 for discharge; U1A, U1B and U1C are all Operation Amplifier, R38 and R39 are voltage sampling divider resistors, U1C acts as voltage signal isolation to protect the MCU voltage sampling port.

As a further improvement of the invention, DA1(BAT54S) in the hot-plug detection circuit is a protective diode used for absorbing the instantaneous large positive and negative voltages on the J5-PIN1 foot and protecting the MOS tube QA1.

The beneficial effects of the present invention are: the battery pack diagnostic method and the battery pack diagnostic device using the battery pack diagnostic method can quickly and comprehensively detect the battery pack and accurately determine the fault location, which improve working efficiency of the maintenance personnel.

The above general description and the following detailed description are intended to be illustrative and not restrictive.

### Brief description of drawings

FIG. 1 is a schematic process diagram of a battery pack diagnostic method of the present invention.
FIG. 2 is a schematic module diagram of a battery pack diagnosis device of the present invention.
FIG. 3 is a schematic diagram showing a discharge port voltage sampling circuit and a charge port voltage sampling circuit.
FIG. 4 is a schematic diagram of a discharge and loading circuit.
FIG. 5 is a schematic diagram of a hot-plugging detection circuit.
FIG. 6 is a schematic diagram of a USB communication circuit.

### Description of embodiment

The exemplary embodiment will be described in detail herein, and the embodiment is illustrated in the accompanying drawings.

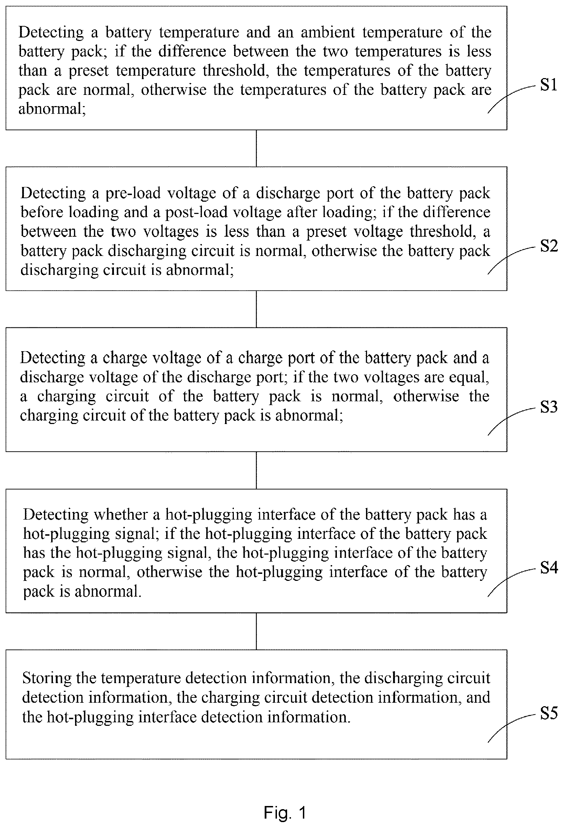

Referring to FIG. 1, the present invention discloses a battery pack diagnostic method. After the battery pack connects to the battery pack diagnostic instrument, the battery pack implements the above diagnosis method and diagnoses the battery pack. The battery pack diagnostic method includes the following steps without particular order:
S1: detecting a battery temperature and an ambient temperature of the battery pack; if the difference between the two temperatures is less than a preset temperature threshold, the state of temperature of the battery pack is instructed as normal, if not, the state of temperature of the battery pack is instructed as abnormal .

The battery temperature refers to the temperature of the battery of the battery pack, and the ambient temperature refers to the temperature of the environment where the battery pack is located. The battery temperature and the ambient temperature can be measured by a temperature detection circuit composed of a temperature sensor. The preset temperature threshold can also be set by the factory or the maintenance personnel according to specific situation, e.g. 1°C, 3°C, 5°C, 7°C or 9°C. In the present embodiment, the preset temperature threshold is 3°C.

Preferably, the step S1 may further include step S11: determining whether the battery pack has been working for a preset time; if so, detecting the battery temperature of the battery pack, otherwise, otherwise detecting the battery temperature of the battery pack after the battery pack has been working for a preset time. This arrangement makes the battery pack have sufficient working time, so that the abnormal temperature problem of the battery pack can be fully reflected, and avoid the abnormal temperature problem of the battery pack from being covered up due to the insufficient working time of the battery pack, thereby effectively improve the accuracy of battery pack diagnosis. The preset time may be preset by the factory and may also be preset by the maintenance personnel according to specific situation. In this embodiment, the preset time might be 10 min, 15 min, 20 min or 30 min, in which 15 min is preferable choice.
S2: detecting a pre-load voltage of a discharge port of the battery pack before loading and a post-load voltage after loading; if the difference between the two voltages is less than a preset voltage threshold, the state of discharging circuit of the battery pack is instructed as normal, if not, the state of discharging circuit of the battery pack is instructed as abnormal;

The pre-load voltage refers to the voltage of the discharge port of the battery pack before loading and the post-load voltage refers to the voltage of the discharge port of the battery pack after loading. The pre-load voltage and the post-load voltage may be measured by the discharge port voltage sampling circuit located at the discharge port. The preset voltage threshold may be set by the factory or the maintenance personnel according to the specific situation. In the present embodiment, the preset voltage threshold is preferably 0.5V, 1V, 1.5V, 2V, 2.5V or 3V, more preferably 1V.
S3: detecting a charge voltage of a battery pack charge port and the discharge voltage of the discharge port; if the two voltages are equal, the state of charging circuit of the battery pack is instructed as normal, if not, the state of charging circuit of the battery pack is instructed as abnormal;

The charge voltage refers to the voltage of the charge port of battery pack during charging and the discharge voltage refers to the voltage of the discharge port of the battery pack during discharging. The charge voltage may be measured by the charge port voltage sampling circuit set at the charge port, and the discharge voltage may be measured by the discharge port voltage sampling circuit set at the discharge port. The present embodiment judges whether the charging circuit of the battery pack is normal by judging whether the charge voltage and the discharge voltage are equal. However, in other embodiments, it is also possible to judge whether the charging circuit of the battery pack is normal by judging whether the difference between the charging voltage and the discharging voltage is less than a preset threshold. The preset threshold may be preset by the factory or set by the maintenance personnel according to the specific situation. As can be understood, the aforementioned two schemes can also coexist and be chosen by the maintenance personnel on a case-by-case basis.

Preferably, the step S3 also includes step S31: detecting whether a charging MOS tube could be turned off; if the charging MOS tube could be turned off, the state of charging circuit of the battery pack is instructed as normal, if not, the state of charging circuit of the battery pack is instructed as abnormal.
S4: detecting whether a hot-plugging interface of the battery pack has a hot-plugging signal; if the hot-plugging interface of the battery pack has the hot-plugging signal, the state of hot-plugging interface of the battery pack is instructed as normal, if not, the state of hot-plugging interface of the battery pack is instructed as abnormal.
S5: storing the temperature detection information, the discharging circuit detection information, the charging circuit detection information, and the hot-plugging interface detection information.

The temperature detection information, the discharging circuit detection information, the charging circuit detection information, and the hot-plugging interface detection information could be stored in the battery pack diagnosis device and could be also stored in an external equipment connected with the battery pack diagnosis device. The external equipment could be a computer, a tablet computer and so on. The abnormal information of the battery pack can be displayed on the display screen, can also be displayed by the fault indicator, and can also indicate the fault type, location and other information through voice prompts.

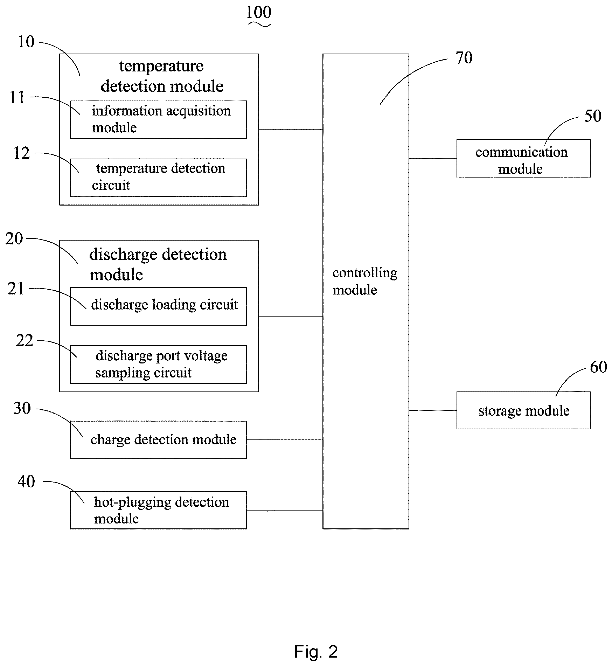

Referring to FIG. 2, the present invention also discloses a battery pack diagnostic device 100 comprising a temperature detection module 10, a discharge detection module 20, a charge detection module 30, a hot-plugging detection module 40, a communication module 50, a storage module 60 and a controlling module 70.

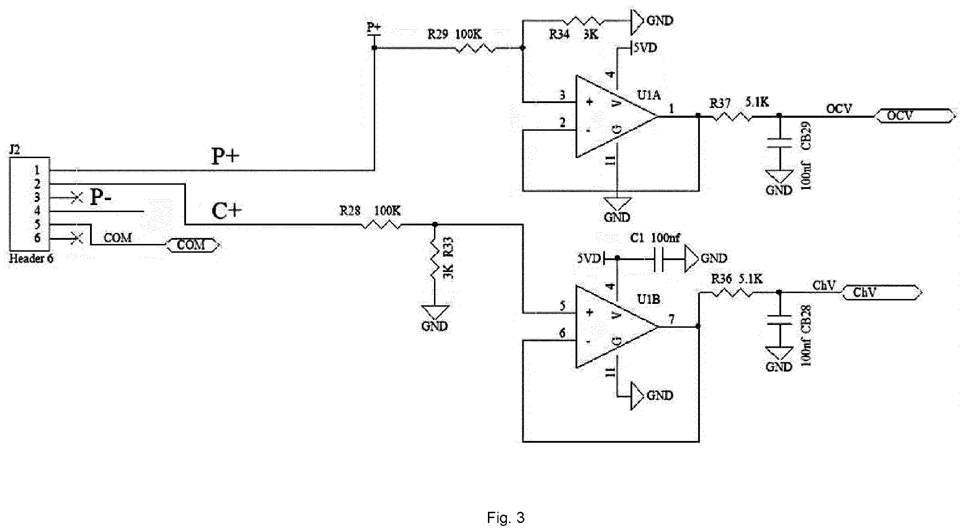

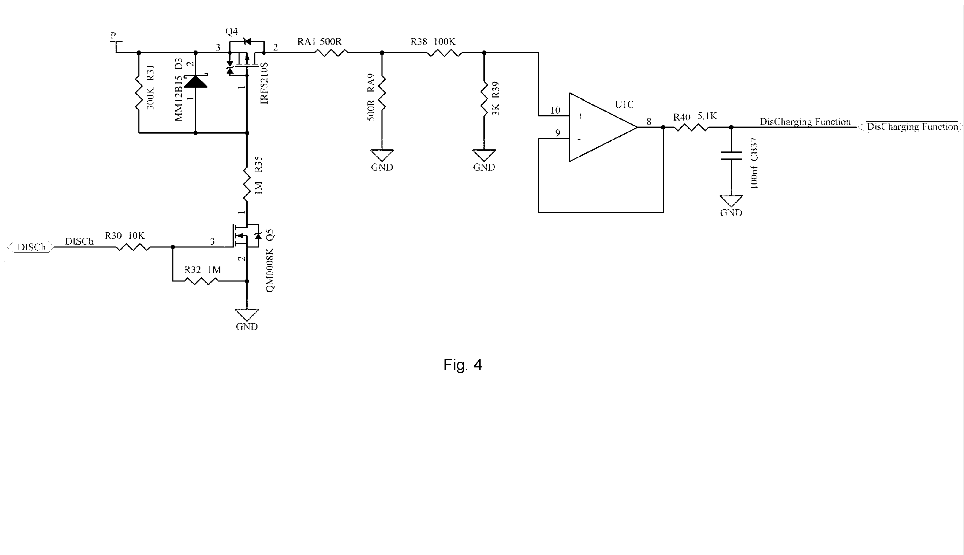

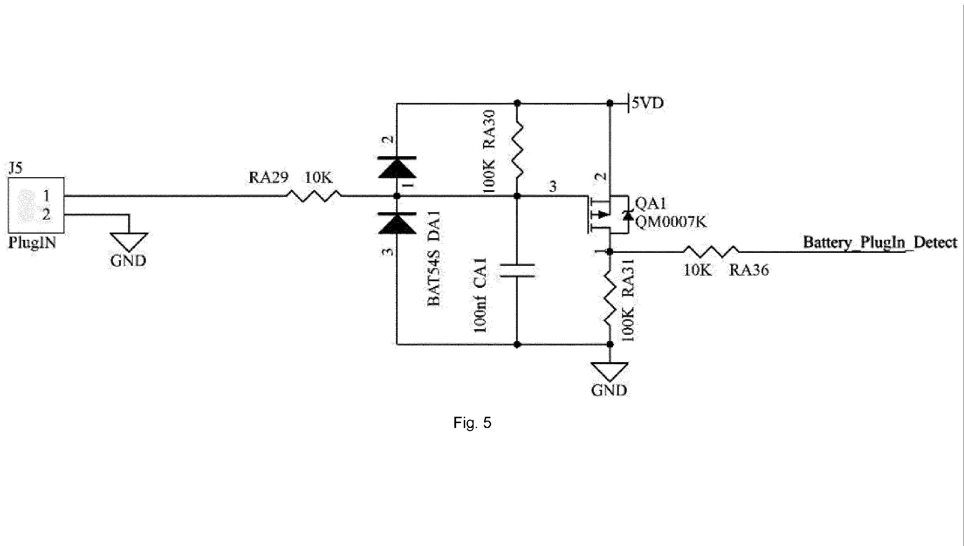

Referring to FIG. 2, the temperature detection module 10 includes an information acquisition module 11 and a temperature detection circuit 12. The information acquisition circuit 11 reads the temperature information of the battery pack through a signal terminal provided on the battery pack. In this embodiment, the battery temperature is obtained by reading the characteristic data of the battery pack by the information acquisition circuit 11. However, in other embodiments, an additional battery temperature detection circuit can also be provided to directly detect the temperature of the cells in the battery pack. The temperature detection circuit 12 is used to detect the ambient temperature of the environment where the battery pack is located. The discharge detection module 20 includes a discharge loading circuit 21 and a discharge port voltage sampling circuit 22. The discharge loading circuit 21 is used to provide a load for the discharge port of the battery pack, and its specific structure is shown in FIG. 4. The discharge port voltage sampling circuit 22 is used to detect the pre-load voltage before the discharge port is loaded and the post-load voltage after the load. The charge detection module 30 includes a charge port voltage sampling circuit for detecting the voltage of the charge port. The discharge port voltage sampling circuit 22 and the charge port voltage sampling circuit are shown in FIG. 3. The hot-plugging detection module 40 includes a hot-plugging detection circuit for detecting whether the hot-plugging interface provided on the battery pack has a hot-plugging signal. The specific structure of the hot-plugging detection circuit is shown in FIG. 5. The storage module 60 is used to store diagnostic information to facilitate maintenance personnel to use in the future and quickly locate the fault location during maintenance. The communication module 50 is used to enable the battery pack diagnostic device 100 to communicate with external devices (for example, a computer, a tablet computer, etc.). The communication module 50 may be a wired communication module or a wireless communication module. The wired communication module may be a USB interface, and the wireless communication module may be a WLAN module, a Bluetooth module, a 5G communication module, an infrared communication module and so on. The present invention does not make specific restrictions on this. The controlling module 70 controls the operations of the temperature detection module 10, the discharge detection module 20, the charge detection module 30, and the hot-plugging detection module 40, and determines whether the battery pack is abnormal by the aforementioned battery pack diagnostic method. The controlling module 70 may be a chip processor, for example: an MCU processor. Analysis software can be run on the external equipment, and the user imports the diagnostic data of the battery pack into the external equipment, so as to obtain a comprehensive diagnostic result of the battery pack through the analysis software, and an electronic analysis report or a printed paper report can be sent to the user.

Referring to FIG. 3 and FIG. 4, Q5 and Q4 are MOS tubes, which act as switches in the circuit in order to load the battery discharge port voltage P+ to the resistors RA1 and RA9 for discharge; U1A, U1B and U1C are all Operation Amplifier, R38 and R39 are voltage sampling divider resistors, U1C acts as voltage signal isolation to protect the MCU voltage sampling port; the discharge loading circuit works as follows: MCU makes the battery discharge terminal (DISCh) generate a signal, at this time Q5 and Q4 is turned on, the discharge port voltage P+ is divided by the resistors R38 and R39 and then applied to the MCU's voltage sampling terminal (DisCharging Function), and then the value of the discharge port voltage P+ is read.

The discharge port and the charge port voltage sampling circuit modules work as follows: the battery discharge port voltage P+ is divided by the resistors R29 and R34, and then isolated by the U1A operation amplifier, and then added to the OCV voltage sampling port of the MCU for voltage sampling processing. The battery charge port voltage C+ is divided by the resistors R28 and R33, and then transmitted and isolated by the U1B, which is finally added to the ChV voltage sampling port of the MCU for voltage sampling processing.

As shown in FIG. 5, DA1 (BAT54S) is a protective diode used to absorb the instantaneous large positive and negative voltages on the J5-PIN1 foot, and protect the MOS tube QA1 and J5 from an external hot-plug switch. When the hot-plug switch is disconnected, QA1 is off, and the voltage of the MCU's Battery_PlugIn_Detect voltage sampling port is 0V. When hot-plug switch is connected, Pin1 and Pin2 of J5 are shorted. At this time, 5VD is divided by RA30 and RA29 to make the GS voltage of MOS tube QA1 greater than the threshold, and then QA1 is turned on. At this time, the voltage of the Battery_PlugIn_Detect voltage sampling port of the MCU is 5V.

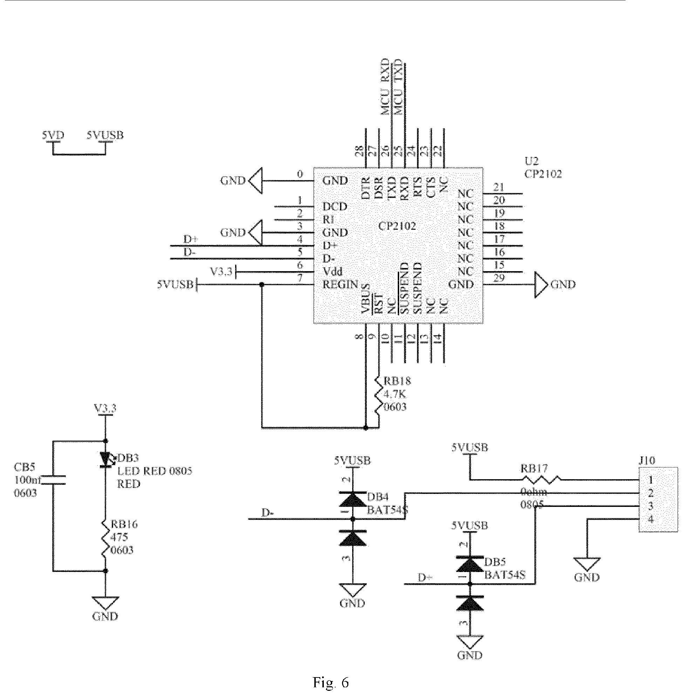

As shown in FIG. 6, the present embodiment uses a USB module as the communication module, uses U2 (CP2102) as a USB-to-serial signal conversion chip, and communicates with the MCU through serial ports TXD and RXD. J10 is a USB interface which can be connected to an external USB cable to thereby communicate with the external equipments (for example, a computer, a tablet computer, etc.). DB4 and DB5 are protective diodes used to absorb the instantaneous large positive and negative voltages of PIN2 and PIN3 on J10 to protect U2.

Compared with the conventional technology, the battery pack diagnostic method and the battery pack diagnostic device 100 of the present invention can quickly and comprehensively detect the battery pack, and accurately locate the fault location, thereby effectively improving the efficiency of maintenance personnel.

The above embodiment is only used to illustrate present invention and not to limits the technical solutions described in present invention, which is defined by the appended claims.

## Claims

1. A battery pack diagnostic method, **characterized in that**, comprising following steps without specific order:
S1: detecting a battery temperature and an ambient temperature of the battery pack; if the difference between the two temperatures is less than a preset temperature threshold, the state of temperature of the battery pack is instructed as normal, if not, the state of temperature of the battery pack is instructed as abnormal;
S2: detecting a pre-load voltage of a discharge port of the battery pack before loading and a post-load voltage after loading; if the difference between the two voltages is less than a preset voltage threshold, the state of discharging circuit of the battery pack is instructed as normal, if not, the state of discharging circuit of the battery pack is instructed as abnormal;
S3: detecting a charge voltage of a charge port of the battery pack and a discharge voltage of the discharge port; if the two voltages are equal, the state of charging circuit of the battery pack is instructed as normal, if not, the state of charging circuit of the battery pack is instructed as abnormal;
S4: detecting whether a hot-plugging interface of the battery pack has a hot-plugging signal; if the hot-plugging interface of the battery pack has the hot-plugging signal, the state of hot-plugging interface of the battery pack is instructed as normal, if not, the state of hot-plugging interface of the battery pack is instructed as abnormal.

2. The battery pack diagnostic method as claimed in claim 1, wherein the step S3 further comprises a step S31: detecting whether a charging MOS tube could be turned off; if the charging MOS tube could be turned off, the state of charging circuit of the battery pack is instructed as normal, if not, the state of charging circuit of the battery pack is instructed as abnormal.

3. The battery pack diagnostic method as claimed in claim 1, wherein the step S1further comprises a step S11: determining whether the battery pack has been working for a preset time; if so, detecting the battery temperature of the battery pack, if not, detecting the battery temperature of the battery pack after the battery pack has been working for the preset time.

4. The battery pack diagnostic method as claimed in claim 1, further comprising a step S5: storing the temperature detection information, the discharging circuit detection information, the charging circuit detection information, and the hot-plugging interface detection information.

5. The battery pack diagnostic method as claimed in claim 1, wherein the preset temperature threshold is 1°C, 3°C, 5°C, 7°C or 9°C.

6. The battery pack diagnostic method as claimed in claim 1, wherein the preset voltage threshold is 0.5V, 1V, 1.5V, 2V, 2.5V or 3V.

7. A battery pack diagnostic device (100), **characterized in that**, comprising:
a temperature detection module (10) comprising an information acquisition circuit (11) for reading a battery temperature information of the battery pack and a temperature detection circuit (12) for detecting an ambient temperature;
a discharge detection module (20) comprising a discharge loading circuit (21) for providing a load to a discharge port and a discharge port voltage sampling circuit (22);
a charge detection module (30) comprising a charge voltage sampling circuit;
a hot-plugging detection module (40) comprising a hot-plugging detection circuit for detecting whether a hot-plugging port has a hot-plugging signal; and
a controlling module (70) configured to control the temperature detection module (10), the discharge detection module (20), a charge detection module (30) and a hot-plug detection module (40), configured to detect whether the battery pack is normal through the battery pack diagnostic method as claim 1.

8. The battery pack diagnostic device as claimed in claim 7, further comprising a communication module (50) for communicating with an external equipment.

9. The battery pack diagnostic device as claimed in claim 8, wherein the communication module (50) is WLAN module, Blue Tooth module, 5G communication module, infrared communication module or USB interface.

10. The battery pack diagnostic device as claimed in claim 8, further comprising a storage module (50) for storing diagnostic informations.

## Patentansprüche

1. Batteriepack-Diagnoseverfahren, **dadurch gekennzeichnet, dass** es die folgenden Schritte ohne spezifische Reihenfolge umfasst:
S1: Erkennen einer Batterietemperatur und einer Umgebungstemperatur des Batteriepacks; wenn die Differenz zwischen den zwei Temperaturen kleiner als ein voreingestellter Temperaturschwellenwert ist, wird der Temperaturzustand des Batteriepacks als normal angewiesen, wenn nicht, wird der Temperaturzustand des Batteriepacks als abnormal angewiesen;
S2: Erkennen einer Vorladespannung eines Entladeanschlusses des Batteriepacks vor dem Laden und einer Nachladespannung nach dem Laden; wenn die Differenz zwischen den zwei Spannungen kleiner als ein voreingestellter Spannungsschwellenwert ist, wird der Zustand eines Entladeschaltkreises des Batteriepacks als normal angewiesen, wenn nicht, wird der Zustand des Entladeschaltkreises des Batteriepacks als abnormal angewiesen;
S3: Erkennen einer Ladespannung eines Ladeanschlusses des Batteriepacks und einer Entladespannung des Entladeanschlusses; wenn die zwei Spannungen gleich sind, wird der Zustand eines Ladeschaltkreises des Batteriepacks als normal angewiesen, wenn nicht, wird der Zustand des Ladeschaltkreises des Batteriepacks als abnormal angewiesen;
S4: Erkennen, ob eine Hot-Plugging-Schnittstelle des Batteriepacks ein Hot-Plugging-Signal hat; wenn die Hot-Plugging-Schnittstelle des Batteriepacks das Hot-Plugging-Signal hat, wird der Zustand der Hot-Plugging-Schnittstelle des Batteriepacks als normal angewiesen, wenn nicht, wird der Zustand der Hot-Plugging-Schnittstelle des Batteriepacks als abnormal angewiesen.

2. Batteriepack-Diagnoseverfahren nach Anspruch 1, wobei der Schritt S3 weiter einen Schritt S31 umfasst: Erkennen, ob eine MOS-Laderöhre ausgeschaltet werden konnte; wenn die MOS-Laderöhre ausgeschaltet werden konnte, wird der Zustand eines Ladeschaltkreises des Batteriepacks als normal angewiesen, wenn nicht, wird der Zustand des Ladeschaltkreises des Batteriepacks als abnormal angewiesen.

3. Batteriepack-Diagnoseverfahren nach Anspruch 1, wobei der Schritt S1 weiter einen Schritt S11 umfasst: Bestimmen, ob das Batteriepack für eine voreingestellte Zeit gearbeitet hat; wenn ja, Erkennen der Batterietemperatur des Batteriepacks, wenn nicht, Erkennen der Batterietemperatur des Batteriepacks, nachdem das Batteriepack für die voreingestellte Zeit gearbeitet hat.

4. Batteriepack-Diagnoseverfahren nach Anspruch 1, das weiter einen Schritt S5 umfasst: Speichern der Temperaturerkennungsinformation, der Entladestromkreis-Erkennungsinformation, der Ladestromkreis-Erkennungsinformation und der Hot-Plugging-Schnittstellen-Erkennungsinformation.

5. Batteriepack-Diagnoseverfahren nach Anspruch 1, wobei der voreingestellte Temperaturschwellenwert 1°C, 3°C, 5°C, 7°C oder 9°C beträgt.

6. Batteriepack-Diagnoseverfahren nach Anspruch 1, wobei der voreingestellte Spannungsschwellenwert 0,5 V, 1 V, 1,5 V, 2 V, 2,5 V oder 3 V beträgt.

7. Batteriepack-Diagnosevorrichtung (100), **dadurch gekennzeichnet, dass** sie umfasst:
ein Temperaturerkennungsmodul (10), das eine Informationserfassungsschaltung (11) zum Lesen einer Batterietemperaturinformation des Batteriepacks und eine Temperaturerkennungsschaltung (12) zum Erkennen einer Umgebungstemperatur umfasst;
ein Entladungserkennungsmodul (20), das eine Entladungsladeschaltung (21) zum Bereitstellen einer Last an einen Entladeanschluss und eine Entladeanschlussspannungs-Abtastschaltung (22) umfasst;
ein Ladungserkennungsmodul (30), das eine Ladespannungs-Abtastschaltung umfasst;
ein Hot-Plugging-Erkennungsmodul (40), das eine Hot-Plugging-Erkennungsschaltung zum Erkennen, ob ein Hot-Plugging-Anschluss ein Hot-Plugging-Signal hat, umfasst; und
ein Steuermodul (70), das dazu konfiguriert ist, das Temperaturerkennungsmodul (10), das Entladungserkennungsmodul (20), ein Ladungserkennungsmodul (30) und ein Hot-Plug-Erkennungsmodul (40) zu steuern, und das dazu konfiguriert ist, durch das Batteriepack-Diagnoseverfahren nach Anspruch 1 zu erkennen, ob das Batteriepack normal ist.

8. Batteriepack-Diagnosevorrichtung nach Anspruch 7, die weiter ein Kommunikationsmodul (50) zum Kommunizieren mit einem externen Gerät umfasst.

9. Batteriepack-Diagnosevorrichtung nach Anspruch 8, wobei das Kommunikationsmodul (50) ein WLAN-Modul, ein Bluetooth-Modul, ein 5G-Kommunikationsmodul, ein Infrarotkommunikationsmodul oder eine USB-Schnittstelle ist.

10. Batteriepack-Diagnosevorrichtung nach Anspruch 8, die weiter ein Speichermodul (50) zum Speichern von Diagnoseinformationen umfasst.

## Revendications

1. Procédé de diagnostic de bloc-batterie, **caractérisé en ce qu'**il comprend les étapes suivantes sans ordre spécifique :
l'étape S1: consistant à détecter une température de batterie et une température ambiante du bloc-batterie ; si la différence entre les deux températures est inférieure à un seuil de température prédéfini, l'état de température du bloc-batterie est indiqué comme normal, sinon, l'état de température du bloc-batterie est indiqué comme anormal ;
l'étape S2 : consistant à détecter une tension de précharge d'un port de décharge du bloc-batterie avant la charge et une tension de postcharge après la charge ; si la différence entre les deux tensions est inférieure à un seuil de tension prédéfini, l'état de circuit de décharge du bloc-batterie est indiqué comme normal, sinon, l'état de circuit de décharge du bloc-batterie est indiqué comme anormal ;
l'étape S3 : consistant à détecter une tension de charge d'un port de charge du bloc-batterie et une tension de décharge du port de décharge ; si les deux tensions sont égales, l'état de circuit de charge du bloc-batterie est indiqué comme normal, sinon, l'état de circuit de charge du bloc-batterie est indiqué comme anormal ;
l'étape S4: consistant à détecter si une interface de branchement à chaud du bloc-batterie présente un signal de branchement à chaud ; si l'interface de branchement à chaud du bloc-batterie présente le signal de branchement à chaud, l'état de l'interface de branchement à chaud du bloc-batterie est indiqué comme normal, sinon, l'état de l'interface de branchement à chaud du bloc-batterie est indiqué comme anormal.

2. Procédé de diagnostic de bloc-batterie tel que revendiqué dans la revendication 1, dans lequel l'étape S3 comprend en outre une étape S31 : consistant à détecter si un tube MOS de charge peut être mis hors tension ; si le tube MOS de charge peut être mis hors tension, l'état de circuit de charge du bloc-batterie est indiqué comme normal, sinon, l'état de circuit de charge du bloc-batterie est indiqué comme anormal.

3. Procédé de diagnostic de bloc-batterie tel que revendiqué dans la revendication 1, dans lequel l'étape S1 comprend en outre une étape S11 : consistant à déterminer si le bloc-batterie a travaillé pendant un temps prédéfini ; si tel est le cas, à détecter la température de batterie du bloc-batterie, sinon, à détecter la température de batterie du bloc-batterie après que le bloc-batterie a travaillé pendant le temps prédéfini.

4. Procédé de diagnostic de bloc-batterie tel que revendiqué dans la revendication 1, comprenant en outre une étape S5 : consistant à stocker les informations de détection de température, les informations de détection de circuit de décharge, les informations de détection de circuit de charge et les informations de détection d'interface de branchement à chaud.

5. Procédé de diagnostic de bloc-batterie tel que revendiqué dans la revendication 1, dans lequel le seuil de température prédéfini est 1 °C, 3 °C, 5 °C, 7 °C ou 9 °C.

6. Procédé de diagnostic de bloc-batterie tel que revendiqué dans la revendication 1, dans lequel le seuil de tension prédéfini est 0,5 V, 1 V, 1,5 V, 2 V, 2,5 V ou 3 V.

7. Dispositif de diagnostic de bloc-batterie (100), **caractérisé en ce qu'**il comprend :
un module de détection de température (10) comprenant un circuit d'acquisition d'informations (11) pour lire une information de température de batterie du bloc-batterie et un circuit de détection de température (12) pour détecter une température ambiante ;
un module de détection de décharge (20) comprenant un circuit de chargement de décharge (21) pour fournir une charge à un port de décharge et un circuit d'échantillonnage de tension de port de décharge (22) ;
un module de détection de charge (30) comprenant un circuit d'échantillonnage de tension de charge ;
un module de détection de branchement à chaud (40) comprenant un circuit de détection de branchement à chaud pour détecter si un port de branchement à chaud présente un signal de branchement à chaud ; et
un module de commande (70) configuré pour commander le module de détection de température (10), le module de détection de décharge (20), un module de détection de charge (30) et un module de détection de branchement à chaud (40), configuré pour détecter si le bloc-batterie est normal au moyen du procédé de diagnostic de bloc-batterie selon la revendication 1.

8. Dispositif de diagnostic de bloc-batterie tel que revendiqué dans la revendication 7, comprenant en outre un module de communication (50) pour communiquer avec un équipement externe.

9. Dispositif de diagnostic de bloc-batterie tel que revendiqué dans la revendication 8, dans lequel le module de communication (50) est un module de réseau WLAN, un module Bluetooth, un module de communication 5G, un module de communication infrarouge ou une interface USB.

10. Dispositif de diagnostic de bloc-batterie tel que revendiqué dans la revendication 8, comprenant en outre un module de stockage (50) pour stocker des informations de diagnostic.
